## Europäisches Patentamt

## European Patent Office

## Office européen des brevets

(11) Veröffentlichungsnummer: **0 007 456**
**B1**

(12) **EUROPÄISCHE PATENTSCHRIFT**

(45) Veröffentlichungstag der Patentschrift:
06.01.82

(51) Int. Cl.³: **G 06 K 15/10, B 41 J 3/04**

(21) Anmeldenummer: 79102159.5

(22) Anmeldetag: 28.06.79

(54) Datenbitübersetzer für einen Matrixdrucker.

(30) Priorität: 21.07.78 US 926679

(43) Veröffentlichungstag der Anmeldung:
06.02.80 Patentblatt 80/3

(45) Bekanntmachung des Hinweises auf die Patenterteilung:
06.01.82 Patentblatt 82/1

(84) Benannte Vertragsstaaten:
**DE FR GB**

(56) Entgegenhaltungen:
**DE-A-2 708 591**
**EP-A-2 699**
**FR-A-2 279 556**
**US-A-3 942 620**
**US-A-4 009 332**
**I.B.M. TECHNICAL DISCLOSURE BULLETIN,**
**Vol. 16, Nr. 5, Oktober 1973**
**Seiten 1594, 1595**
**Armonk, New York, U.S.A.**
**F. TSUI: »Arrangement for Data**
**Merging and Line Splitting in Printers«**

(73) Patentinhaber: **International Business Machines Corporation, Armonk, N.Y. 10504 (US)**

(72) Erfinder: **Nosowicz, Eugene James, 152 Meadowbrook Lane, Vestal, New York 13850 (US)**
Erfinder: **Pearson, Robert Charles, 19 Brook Street, Newark Valley, New York 13811 (US)**

(74) Vertreter: **Kirchhof, Norbert, Ing. grad., Schönaicher Strasse 220, D-7030 Böblingen (DE)**

## Datenbitübersetzer für einen Matrixdrucker

Die Erfindung bezieht sich auf einen Datenbitübersetzer gemäß Oberbegriff des Anspruchs 1.

Matrixdrucker bilden Aufzeichnungen oder Zeichen durch Druck diskreter Teile oder Fragmente an geeigneten Stellen. Beispiele für Matrixdrucker stellen Tintenstrahldrucker, Laserdrucker, Elektroerosionsdrucker, elektrolytische Drucker und Drahtdrucker dar. Derartige Drucker erfordern das Steuern einer großen Anzahl von Datensignalen, da jede aufzueichnende Markierung eine Datenbitinformation erfordert und verschiedene Takt- und Torimpulse. Die Datenmanipulation und Übertragung wird noch schwieriger und komplexer, um so höher die Druckqualität ist, d. h., wenn die Anzahl der Druckelemente pro Druckfeldeinheit größer wird.

Bei manchen Matrixdruckern (z. B. IBM Technical Discloseue Bulletin, Vol. 16, No. 5, Oktober 1973, S. 1594, 1965 und DE-AS 2 317 596) insbesondere bei bestimmten Tintenstrahldruckern hat das Feld von Markiervorrichtungen eine Länge, die ausreicht, um gleichzeitig mehrere Druckzeilen während eines einzigen Überstreichens des Druckkopfes quer über das zu bedruckende Papier zu drucken. Dieser relativ weite Markierungsbereich gestattet das Aufzeichnen von Markierungen oder Zeichen an beinahe jedem Punkt innerhalb der Länge des Markierungsfeldes. Wird angenommen, daß der Druckkopf in üblicher Weise relativ gegenüber dem zu bedruckenden Papier bewegt wird, kann das Drucken mit verschiedener Anzahl von Zeilen pro Millimeter stattfinden oder kann sogar so gesteuert werden, um nicht zwangsläufige Graphiken aufzuzeichnen. Die Zeichen müssen nicht an bestimmten vertikalen Orten erscheinen, sogar für ein vorgegebenes Standardformat. Die Zeichenpositionsunterschiede müssen an die oberste und unterste jeweilige Beschriftung, an Tief- und Hochstellungen von Zeichen und an überstrichene Zeichen angepaßt werden. Mit anderen Worten, ein Zeichen muß irgendwo innerhalb der vertikalen Aufzeichnungsbreite des Druckkopfes während seiner Bewegung plaziert werden. Die tatsächliche Position des Zeichens wird definiert durch die Grundlinie oder Startadresse.

Die Information, die ein zu druckendes Zeichen beschreibt, ist in einer Einheit enthalten, die gewöhnlich ein Zeichengenerator darstellt. Dieser Zeichengenerator enthält alle Bytes von binären Daten, die erforderlich sind, für jedes zu druckende Zeichen und kann die Daten von mehreren Schriftarten enthalten. Wenn die Daten für jedes Zeichen als Matrix von binären Bits darzustellen sind, in welcher jede Spalte ein Byte oder mehrere Datenbits ist und verschiedene Zeichen gleichzeitig zu drucken sind, sind viele Bytes von Daten aus dem Zeichengenerator herauszuholen, um die Daten für eine einzige Spalte von Markierungen dem Druckkopf zu liefern. Jede Markierungsvorrichtung ist dann zu steuern, als ob sie eine Markierung zu erzeugen hätte. Datenbytes für jedes Zeichen werden gewöhnlich aus dem Zeichengenerator nicht in vertikaler Reihenfolge des Erscheinens heraus geholt, um die Steuerverriegelungsschaltungen für die Markierungsvorrichtungen zu füllen und müssen wieder geordnet werden, um in der richtigen Position zur Zeit, an der das Drucken erfolgt, zu erscheinen. Deshalb müssen die Datenbytes wieder geordnet werden und in der geeigneten Verriegelungsschaltungen plaziert werden für den Augenblick des Druckens.

Wenn die Daten aus dem Zeichengenerator herausgeholt wurden, geschah dies entweder auf einer bestimmten Grundlinie für jede Druckzeile oder es erforderte die vorläufige Organisation umfangreiche Datenübertragungen in zeitliche Puffer, um eine Entnahme in ordentlicher Reihenfolge zu gestatten. Die früheren Techniken erforderten komplexe und teure Schaltkreise und größere Übertragungszeiten für das Übertragen einer Menge von Aufzeichnungsdaten, da die Daten serial übertragen wurden.

Die Erfindung, wie sie in den Ansprüche gekennzeichnet ist, löst die Aufgabe, eine Datenbitübersetzer der im Oberbegriff des Anspruches 1 genannten Art zu schaffen, der ein flexibles Aussichten und Zusammensetzen des Spalteninhaltes, ggf. unter Einbeziehung von Elementen mehrerer Zeichen erlaubt.

Die durch die Erfindung erzielten Vorteile sind im wesentlichen darin zu sehen, daß infolge der gewählten Art von Speicherzellen jede Zelle setzbar ist, um ein gespeichertes Bit anzuzeigen jedoch nur dann rückstellbar ist, wenn das gesamte Speicherfeld rückgestellt wird, was durch ein Überdrucken von Daten durch ein folgendes Byte oder Wort möglich ist. Es ist auch möglich, die Grundlinie für jede Druckzeile auszuwählen ohne Rücksicht auf die Folge, welcher die Daten vom Zeichengenerator erhalten werden. dadurch ergibt sich ein breiter Bereich, innerhalb dessen eine Format-Auswahl beim Druck möglich ist.

Einzelheiten der Erfindung sind nachstehend anhand eines in den Figuren veranschaulichten Ausführungsbeispieles beschrieben.

Es zeigen

Fig. 1 ein Schema eines bevorzugten Ausführungsbeispieles der Erfindung,

Fig. 2 den Bitauswähler der Fig. 1 im Detail und

Fig. 3 eine Anordnung von Bitspeicherzelle die in dem Schieberegister der Fig. 1 verwenbar ist.

Der Druckkopf 10 wird so gesteuert, um aufzuzeichnende Zeichen 11 aus einer Vielzahl von wahlweise erzeugbaren und anordenbaren Markierungen während der Relativbewegung zwischen dem Druckkopf 10 und dem bedruckenden Papier 12 zu erzeugen. /

Drucker ist ein Tintenstrahldrucker gezeigt, dessen Druckelemente eine Vielzahl von Düsen 13 darstellen. Obwohl im Detail nicht dargestellt, besitzt ein derartiger Druckkopf gewöhnlich eine oder mehrere Reihen von Düsen, aus denen Tropfen kontinuierlich gegen das zu bedruckende Papier ausgestoßen und abgelenkt oder in eine Auffangblende geleitet werden, um auf das Papier nicht aufzutreffen. Wenn eine Markierung aufzuzeichnen ist, wird das Potential von einem Ladering an einer Düse genommen, wodurch auf einem oder mehreren Tröpfchen keine Ladung induziert wird, wodurch sich dieselben gegen das zu bedruckende Papier bewegen. Zu anderen Zeiten werden Tröpfchen durch das Laderingpotential aufgeladen und werden durch die elektrostatischen Ablenkelektroden angezogen, um in der Tintenauffangblende aufzuschlagen. Somit ist die tatsächliche Druckersteuerung in der Zuführung von Signalen zu den Ladeelektroden einer jeden Düse zu sehen, um ein Zeichen zusammenzusetzen. In ähnlicher Weise werden bei anderen Matrixdruckvorrichtungen elektrische Signale verwendet, um die Zeichenelemente in ähnlicher Weise zu steuern, beispielsweise durch Aktivierung von Druckdrähten durch Unterbrechen eines Lichtstrahles oder durch Errodieren oder Verändern der Farbe des Aufzeichnungsmateriales mittels eines Stromimpulses.

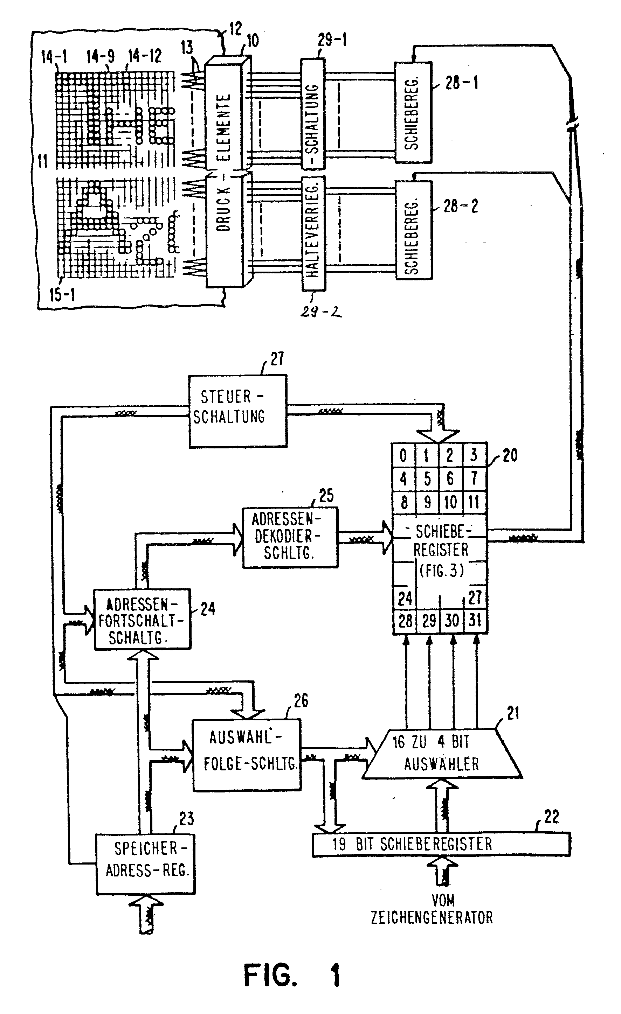

Die Zeichen sind aus binären Datenbytes zusammengesetzt, die aus einem Zeichengenerator ausgelesen werden und schließlich in geeigneter Weise den Druckelementen oder Laderingen der Düse zugeführt werden, um die Aufzeichnung zu steuern. Der von einem Düsenfeld des Druckkopfes 10 bedeckte Bereich ist von ausreichender Breite, um gleichzeitig eine Mehrzahl von Druckzeilen aufzuzeichnen, während der Relativbewegung zwischen dem Druckkopf und dem Aufzeichnungsträger. Es müssen somit Daten für einen vertikalen Teil eines jeden Zeichens aus dem Zeichengenerator aus einer Mehrzahl von Worten entnommen werden und für das Aufzeichnen in einer einzigen Spalte von Tropfen an geeigneten Stellen umgewandelt werden. Wie aus Fig. 1 ersichtlich ist, besteht jedes Zeichen aus einer Mehrzahl von vertikalen Datenbytes, von denen ein jedes einen Binärwert enthält, das das Aufzeichnen einer Markierung durch eine Düse anzeigt.

In Abhängigkeit von der Länge des Düsenfeldes sind mehrere Datenwörter oder Bytes notwendig zum Druck einer einzigen vertikalen Spalte entlang des Ausmaßes der Düsenreihe. Diese Bytes werden aufeinanderfolgend aus unterschiedlichen Teilen des Generators entnommen, und zwar während des Intervalles zwischen aufgezeichneten Markierungsspalten und ihrer Lieferung zum Druckkopf als Lade-Steuersignale. In Fig. 1 weist der Druckkopf 32 Düsen auf oder ein Adäquat für zwei 16-Bitbytes von Daten. Zusätzliche Düsen und entsprechende Schaltkreise können für größere Druckköpfe natürlich vorgesehen sein. In Fig. 1 erfordert die erste oder äußerst links angeordnete Tropfenspalte zwei 16-Bitbytes mit dem obersten Byte 14-1, das drei »1«-Bits für das »T« enthält und das untere Byte 15-1, das zwei Datenbits für die äußerste linke Seite des »A« enthält. Diese Bytes werden aus dem Speicher (nicht gezeigt) entnommen und zur Übermittlung zu den Düsenladeelektroden umgewandelt.

Bei der gedruckten Zeichenanordnung sind wenigstens zwei Bytes notwendig, für das Drucken einer jeden Spalte bei rechtsgerichteter Fortbewegung des Druckkopfes entlang dem zu bedruckenden Papier. Im Falle des Überdruckens, wie weiter unten beschrieben ist, müssen ein oder mehrere extra Bytes entnommen werden. Die Erfindung befaßt sich mit dem Übersetzen bzw. Umwandeln der entnommenen Datenbytes und ihrer Organisation für die Bereitstellung an den Druckelementen oder Ladeelektroden. Die Zeichenauswahl und die Datenentnahme vom Zeichengenerator ist nicht Teil der Erfindung und deshalb nicht eingehender beschrieben.

Der Datenbitübersetzer gemäß der Erfindung besteht aus einem Bitübersetzer mit einem Schieberegister-Matrixfeld 20, das eine Mehrzahl von Schieberegistern enthält, die in Reihen und Spalten angeordnete Binärdatenbits-Speicherzellen enthalten, einen Bitauswähler 21 zur Lieferung der Datenbyte-Untergruppen zum Bitübersetzer entlang der Spalten des Feldes, das 19-Bit-Schieberegister 22 zur Lieferung von Daten zum Bitauswähler, das Speicher-Adreßregister 23 zur Spezifierung der Feldadresse, in welcher die Butuntergruppen aufzuzeichnen sind, die Adressen-Fortschaltschaltung 24 zur Veränderung der Feldadresse, die Adressen-Decodierschaltung 25 zum Durchlassen der ausgewählten Feldreihen, die Auswahl-Folge-Schaltung 26 zum Verschieben der entnommenen Datenbytes und zum Auswählen der gewünschten Untergruppen und die Steuerschaltung 27 zum Steuern des Schieberegisterfeldes mittels Torimpulse.

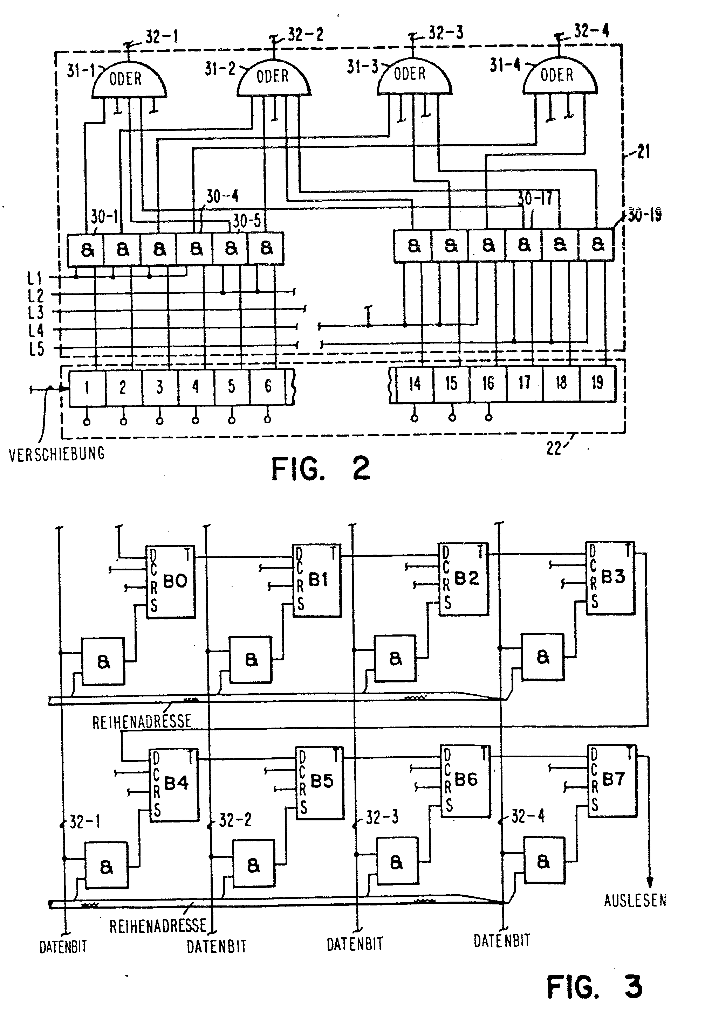

Das Feld 20 auch Schieberregisterfeld oder Übersetzerfeld genannt) enthält eine Mehrzahl von Schieberegistern, von denen zwei gezeigt sind und ein jedes 16-Bit-Speicherzellen aufweist, in die parallel eingeschrieben werden kann und aus denen mittels Taktimpulsen Daten serial auslesbar sind in ein jeweiliges Serien-Parallel-Schieberegister 28-1 oder 28-2 des Druckkopfes. Von dort werden die Daten den jeweiligen Gruppen von Halteverriegelungsschaltungen 29-1 und 29-2 für die Ladeelektrodentreiber übertragen. Die Schieberegisterstufen in dem Feld 20 sind in einer Matrix aus Reihen und Spalten von Zellen angeordnet, von denen eine jede Reihe vier Zellen enthält und in der gezeigten Folge verbunden sind. Jedes Schieberegister im Feld 20 ist gruppiert für ein Schreiben in Reihen von 4. Die Bit-Speicherzellen enthalten eine Spalte im Schieberegisterfeld und sind zusammen mit der Ausgangsleitung von dem 16- zu 4-Bit-Auswähler 21 verbunden. Jedoch können Daten in diesen Speicherzellen von dem bitauswähler nur dann eingeschrieben werden, wenn eine Zellenreihe, wie die Zellen 0 bis 3 oder 4 bis 7 durch Torimpulse der Adreß-Decodierschaltung 25 vorbereitet sind. Die Datenbytes für das Speichern innerhalb des Feldes 20 werden von dem Zeichengenerator oder einer anderen Quelle entnommen und zunächst dem 19-Bit-Schieberegister 22 zugeführt als eine Folge von einzelnen Bytes. Jedes Byte wird dann parallel in den Bitauswähler 21, der im Detail in Fig. 2 gezeigt ist, übertragen.

Die Fähigkeit zum wahlweisen Aufzeichnen eines Zeichens oder einer anderen Markierung an irgendeinem Ort innerhalb des Druckkopfes ist höchst erwünscht und macht somit alle Punkte der Aufzeichnungsfläche für das Markieren adressierbar. Die Erfindung ermöglicht dies durch das 19-Bit-Schieberegister 22, den Bitauswähler 21 und das Feld 20. Ein vom Zeichengenerator entnommenes Datenbyte wird parallel den ersten 16-Bitpositionen des 19-Bit-Schieberegisters 22 (Fig. 2) übermittelt. Zur Zeit der Übermittlung wird eine 7-Bit-Adresse, die Bit-Übersetzer-Zeilenadresse genannt wird, in das Speicher-Adreßregister 23 geladen. Die zwei niedrigeren Bits dieser Adresse werden benutzt, um die Daten auf die Feldspalten auszurichten. Die fünf höherstelligen Bits werden benutzt für das Auswählen der Feldreihe, in welcher die Spaltenbits zu speichern sind.

Ein im Kabel vom Zeichengenerator auftretendes Datenbyte wird zeitlich in den ersten 16 Stufen des Schieberegisters 22 gespeichert, von denen eine jede einer Bitposition des Bytes entspricht. Der Ausgang einer jeden dieser Stufen ist mit UND-Schaltungen 30-1 bis 30-19 (Fig. 2) verbunden. Die letzteren werden durch die Ladeleitungen L1 bis L5 in Vierergruppen vorbereitet, außer für L5, die nur die letzten drei Stufen des Registers 22 vorbereitet. Die Ausgänge der ersten vier UND-Schaltungen 30-1 bis 30-4 sind mit jeweiligen ODER-Schaltungen 31-1, 31-2, 31-3 und 31-4 verbunden. Die zweite Gruppe von vier UND-Schaltungen ist mit den gleichen ODER-Schaltungen verbunden, wiederum in fortlaufender Reihenfolge mit der UND-Schaltung 30-5, die mit der ODER-Schaltung 31-1 verbunden ist und der UND-Schaltung 30-6, die mit der ODER-Schaltung 31-2 verbunden ist usw.

Im Falle der letzten drei Stufen des Schieberegisters 22 sind die UND-Schaltungen 30-17 bis 30-19 mit den ODER-Schaltungen 31-1 bis 31-3 verbunden. Wenn das im Register 22 gespeicherte Byte nicht zu verschieben ist, sind die Ladeleutungen L1 bis L5 aufeinanderfolgend erregt, um die Bits von den Registerstufen über die UND-Schaltungen und ODER-Schaltungen den Spalten von Speicherzellen in dem Schieberegisterfeld 20 zu übertragen, die mit den Ausgängen 32-1 bis 32-4 der jeweiligen ODER-Schaltungen verbunden sind. Wenn die Stufen 30-17, 30-18 und 30-19 des Auswählers 21 nicht gesetzt sind, werden keine Daten zur Leitung L5 übertragen. Um dem Datenbyte im Register 22 zu gestatten, in irgendeiner Position des Schieberegisters gespeichert zu werden, wird es durch zwei niedrigstellige Bits der Speicheradresse von der Schaltung 23 über die Auswahlfolgeschaltung 26 übertragen. Diese zwei Bits können das Starten des Anfangsbits im Datenbyte-Register 22 in irgendeiner der vier Spalten hervorrufen. Wenn die zwei niedrigstelligen Bits beide 0 sind, tritt keine Verschiebung auf, bevor die Ladeleitungen L1 bis L5 aufeinanderfolgend erregt sind. Wenn die zwei niedrigstelligen Bits keine Nullen sind, wird eine Verschiebung hervorgerufen, um die Daten mit dem Auswähler auszurichten. Diese Daten müssen um das binäre Äquivalent der zwei niedrigstelligen Bits nach rechts verschoben werden. Beispielsweise ist für Bits 0, 1, eine einzige Verschiebung erforderlich, für 1,0 eine Doppelverschiebung und für 1,1 eine Dreifachverschiebung. Sobald die Verschiebung erfolgt ist, erfolgt das normale Laden des Feldes.

Die gewünschte Reihe des Schieberegisterfeldes in Fig. 1 wird ausgewählt durch die fünf höherstelligen Bits der Speicher-Adreßschaltung 23. Diese fünf Bits schleusen die ausgewählte Reihe von Speicherzellen im Feld 20 durch die Adressen-Fortschaltung 24 und die Adressendecodierschaltung 25. Diese Speicheradresse bereitet somit die erste ausgewählte Reihe von vier Zellen vor, die entsprechend den Daten in den vier Bitpositionen der Stufen im Register 22 zu setzen sind, wenn die entsprechende der Ladeleitungen L1 bis L5 erregt ist.

Wenn z. B. die Ladeleitung L1 erregt ist, können die ersten vier Bits in der vierten Reihe plaziert werden, worauf die Adressen-Fortschaltung 24 die Reihenadresse um eins aufeinanderfolgend für jede Erregung der restlichen Ladeleitungen L2 bis L5 verändert. Die Adressen-Fortschaltschaltung 24 wird vorzugsweise in einen »Überlauf« gesetzt, bei den Anfangsreihen des Feldes, wenn das Adressieren die letzte Reihe des Feldes erreicht. Die Steuerschaltung 27 steuert das Fortschalten der Adresse und die Anwendung der Torimpulse in verschiedenen Speicherzellen des Feldes.

Das Feld 20 wurde gezeigt mit mindestens zwei Schieberegistern, von denen ein jedes 16 Speicherzellen aufweist. Das erste Register hat die Zellen 0 bis 15 und das zweite die Zellen 16 bis 30. Bisher wurden Datenbytes von einer Länge von 16 Bits zugrunde gelegt. Es sind jedoch auch andere Wort- oder Bytelängen verwendbar. Die Anzahl der Speicherzellen in den Schieberegistern des Feldes kann frei gewählt werden. Aus dem Bishergesagten ist ersichtlich, daß ein Datenbyte in den Speicherzellen an irgendeiner Position aufgezeichnet werden kann und hierbei eine Grundlinienadresse in irgendeiner Position entlang der Länge des Druckkopfes liefert.

Nachdem die Daten in dem Registerfeld 20 gespeichert wurden, wird die Steuerschaltung 27 wirksam für ein Auslesen der verschiedenen Schieberegister, aus denen das Feld besteht. I

diesem Falle wird der Schiebeimpuls den zwei Registern gleichzeitig zugeführt und die Daten aus jedem der zwei Schieberegister gleichzeitig serial ausgelesen und den Schieberegistern 28-1 und 28-2 zugeführt. Hernach werden die zuletztgenannten beiden Schieberegister durch Torimpulse vorbereitet für ein Auslesen der gespeicherten Bits parallel in die Halteverriegelungsschaltungen, die wirksam sind für ein Erregen der Laderinge in Übereinstimmung mit den durch die Düsen 13 aufzuzeichnenden Markierungen.

In Fig. 3 ist eine Anordnung von Bit-Speicherzellen gezeigt, die mit dem Schieberegisterfeld nach Fig. 1 verwendbar ist. Nur zwei Reihen der Matrix sind gezeigt und sind repräsentativ für die übrigen Zellen. Diese Speicherzellen B0 bis B7 können in bekannter Weise aus flankengetriggerten Schiebeverriegelungsschaltungen mit freier Setz(S)- oder Rückstell(R)-Fälligkeit bestehen. Mit den Setz- und Rückstelleitungen in einem inaktiven logischen Zustand (logische 0) wird die Verriegelungsschaltung durch den Taktgeber (C) und die Datenleitungen (D) gesteuert. Wenn die Datenleitungen einen Übergang von dem inaktiven Zustand in den aktiven Zustand (logische 1) hervorrufen, wird der logische Wert der Datenleitungen der Ausgangsklemme zugeführt. Das logische Komplement der Datenleitungen wird gleichzeitig der Komplementausgangsklemme zugeführt. Die Übertragung von dem Dateneingang zum Ausgang tritt nur dann ein, wenn der Taktgebereingang einen Übergang macht. Sobald der Übergang erfolgt ist, verbleiben an den Ausgangsklemmen die Werte, die während des letzten Taktgeberübergangs erhalten wurden, wenn derselbe nicht erfolgt ist durch die Setz- oder Rückstelleingänge oder einen späteren Taktgeberübergang.

Wenn der Setzeingang in seinen aktiven Zustand gebracht wurde, herrscht an der Ausgangsklemme eine logische 1 und an der Komplement-Ausgangsklemme eine logische 0. Der Taktgeber kann nicht wirken, bis der Setzeingang in seinen inaktiven Zustand gebracht wurde. Sobald die Verriegelungsschaltung gesetzt wurde und der Setzeingang in seinen inaktiven Zustand zurückgekehrt ist, verbleibt die Verriegelungsschaltung in dem Setzzustand, bis sie durch eine andere Kombination von Eingängen verändert ist. Das Rückstellen ruft hervor, daß an der Ausgangsklemme eine logische 0 erscheint und an der Komplementklemme eine logische 1, wenn der aktive Zustand hervorgerufen ist. Das Rückstellen mach auch die Taktsignale nichtig und sperrt gleichzeitig das Setzen und Rückstellen.

Zum Beginn des Ladezyklusses des Schieberegisters wird das Feld rückgestellt, wobei die Rückstelleitungen aller Zellen des Feldes verwendet werden, die gemeinsam verbunden sind. Das Feld wird dann geladen durch Beeinflussung der Setzleitungen, durch die Wechselwirkungen der Datenbits und Adreßleitungen. Wenn das Laden fertig ist, wird der Schiebe-Taktgeber aktiviert und für jeden Übergang des Taktgebers werden die Daten um eine Position im Schieberegister weiterbewegt. Das Verschieben erfolgt, bis alle Daten übertragen sind.

Die Erfindung ermöglicht auch ein Überlappen von Zeichen, bei welchem ein Zeichen durch ein anderes auf dem zu bedruckenden Papier überlagert werden kann. Dies ist ausführbar ohne einen Rückschritt mit anschließendem Überdrucken oder durch Vorsehen eines Speicherplatzes für die besondere Zeichenkonfiguration. Da das Schieberegisterfeld 20 Verriegelungsschaltungen verwendet, die eine Veränderung einer 1 in eine logische 0 nicht erlauben, außer bei einem totalen Feldrückstellen, können Datenbytes von zwei Zeichen in einem Zeichengenerator aufeinanderfolgend in dem Feld gespeichert werden und nur jene Zellen, die signifikant für die Datenbits sind, werden gesetzt. Diese Technik wird verwendet, um das Datenbyte aufzubauen, das gezeigt ist für die aufgezeichneten Datenbytes von 14-9 bis 14-12 in Fig. 1, in denen Teile des »H« gleichzeitig gespeichert sind mit dem oberen Balken des »T«. Die Datenbytes des »T« und des »H« sind in gemeinsamen Reihen von Zellen innerhalb des Schieberegisterfeldes 20 eingeschrieben vor der Überführung jener Reihen zu den Schieberegistern 28 und Halteverriegelungsschaltungen 29. Diese Fähigkeit wird gewöhnlich dann gewünscht, wenn ein Hochsetzen von Zeichen über horizontale oder vertikale Linien erwünscht ist, die sich über die volle Länge eines Datenbytes erstrecken.

Obwohl die Erfindung anhand eines Paars von Schieberegistern in dem Übersetzerfeld 20 erläutert wurde, ist auch eine andere Anzahl von Schieberegistern verwendbar und die Anzahl der Zellen in den Reihen und Spalten kann an die vorliegenden Gegebenheiten ebenfalls angepaßt werden. Es ist aus dem zuvor Beschriebenen klar ersichtlich, daß das Verschieben der Daten innerhalb des Feldes nicht durch die Schieberegisterlänge bestimmt ist und die Grenzen keine Einschränkungen in der Anordnung der Daten erfordern. Die Schaltungsanordnungen gewähren selbst in der Ausführung einer großflächigen integrierten Schaltung eine Hochgeschwindigkeits-Datenübertragung und billige Konstruktion. Die Notwendigkeit des Vorsehens eines Ausleseadressierens aus dem Feld ist eliminiert, wodurch die Komplexität weitgehend vermindert ist.

**Patentansprüche**

1. Datenbitübersetzer für einen Matrixdrucker mit einer Mehrzahl von jeweils eine Spalte (14-1 bis 15-1) druckenden Druckelementen, die durch Binärsignale einzeln wahlweise ansteuerbar sind, mit einer Speicherzelle für jedes Druckelement (13), wobei die für alle Druckelemente vorgesehenen Speicherzellen matrixförmig angeordnet sind und die Reihen der Matrix für wahlweises Parallelspeichern adressierbar sind, gekennzeichnet durch folgende Merkmale:

a) Die Speicherzellen erlauben ein serielles Auslesen innerhalb einer jeden Matrixreihe und die Matrixreihen sind aufeinanderfolgend auslesbar;

b) ein Puffer (22) mit einer Mehrzahl von Speicherplätzen zur parallelen Aufnahme von zumindest einem Teil der Binärsignale vor deren seriellem Einspeichern in die Matrix;

c) zwischen dem genannten Puffer (22) und den Speicherzellen-Spalten ist ein Bitauswähler (21) zum Auswählen einer der Anzahl der Spalten der Matrix entsprechenden Anzahl von nebeneinanderliegenden Bits aus dem Puffer mittels einer Auswahlfolgeschaltung (26) zwischengeschaltet, wobei das erste dieser Bits aus einer beliebig wählbaren Binärstelle des Puffers ausgelesen werden kann;

d) Schaltungen (23, 25) zur Adressierung von vorherbestimmten Matrixreihen für ein aufeinanderfolgendes Einspeichern von Gruppen von Bits, die nach ihrer Auswahl durch den Bitauswähler an den Speicherzellen-Spalten erscheinen;

e) Schaltungen (27, 28, 29), die ein bitserielles Auslesen der Binärsignale sequentiell aus aufeinanderfolgenden Matrixreihen in die Druckelemente der Spalte ermöglichen.

2. Datenbitübersetzer nach Anspruch 1, dadurch gekennzeichnet, daß die Matrix durch eine Mehrzahl von Schieberegistern gebildet ist, von denen ein jedes für ein serielles Auslesen der Binärsignale vorgesehen ist.

3. Datenbitübersetzer nach Anspruch 1, dadurch gekennzeichnet, daß jede Reihe von Speicherzellen vor ihrem Auslesen mehrere Male mit Gruppen von Datenbits überschreibbar ist.

4. Datenbitübersetzer nach Anspruch 2, dadurch gekennzeichnet, daß die Schieberegister gleichzeitig in die jeweils zugeordneten Gruppen von Druckelementen (13) auslesbar sind.

5. Datenbitübersetzer nach Anspruch 4, dadurch gekennzeichnet, daß den Druckelementen (13) ergänzende Speicher (28, 29) für das Auslesen aus den genannten Schieberegistern zugeordnet sind.

6. Datenbitübersetzer nach Anspruch 1, dadurch gekennzeichnet, daß der Pufferspeicher (22) ein Verschieben der Binärsignale um wenigstens eine Spalte bezüglich des Datenbitübersetzers ermöglicht.

7. Datenbitübersetzer nach Anspruch 1, dadurch gekennzeichnet, daß der Puffer (21) ein Verschieben der Binärsignale um eine Anzahl von Stufen ermöglicht, die kleiner ist als die Anzahl der Spalten des Datenbitübersetzers (20).

8. Datenbitübersetzer nach Anspruch 1, dadurch gekennzeichnet, daß zwischen die als Speicheradreßregister ausgebildete Schaltung (23) und die als Adressendecodierschaltung ausgebildete Schaltung (25) eine Adressen-Fortschaltschaltung (24) zwischengeschaltet ist zum Verändern der Adresse der aufeinanderfolgenden Reihen von Speicherzellen zum Speichern zusätzlicher Gruppen von Bits, bis das gesamte Datenbyte vollständig gespeichert ist und daß eine Steuerschaltung (27) vorgesehen ist zur Übertragung der Datenbits zu den Druckelementen (13) in serialer Form aus den Spaltenposition in einer Reihe und von einer Mehrzahl dieser Reihen.

9. Datenbitübersetzer nach Anspruch 8, dadurch gekennzeichnet, daß die Adressen-Fortschaltschaltung (24) die Adresse um eine Anzahl fortschaltet, die gleich ist der Anzahl von Gruppen von Daten eines Datenbytes.

10. Datenbitübersetzer nach Anspruch 1, dadurch gekennzeichnet, daß die Speicherzellen der Matrix (20) aus ihrem Rückstellzustand in ihren Setzzustand nur dann schaltbar sind, wenn zur Speicherung Daten zur Verfügung stehen, ungeachtet, wie oft die Speicherzellen zu adressieren sind.

## Claims

1. Data bit assembler for a matrix printer having a multiplicity of print elements, each printing one column (14-1 to 15-1), which print elements are each selectively addressable by means of binary signals, and having a storage cell for each print element (13), the storage cells for all the print elements being arranged in matrix form and the rows of the matrix being addressable for selective parallel storage characterised by the following features:

a) the storage cell matrix permits a seria readout within each matrix row, and the matrix rows are readable in succession;

b) a buffer (22) with a plurality of storage positions for receiving in parallel at leas some of the binary signals prior to thei serial storing in the matrix;

c) between the said buffer (22) and the storag cell columns, a bit selector (21) is provide for selecting a number, corresponding to th number of matrix columns, of contiguou bits from the buffer by means of a selecto sequence (26), the first selected bit bein available from a discretionary binary pos tion of the buffer;

d) circuits (23, 25) for addressing predete mined matrix rows for the successive storin of bit groups which, after their selection b the bit selector, appear at the storage ce columns;

e) circuits (27, 28, 29) permitting a bit-seri readout of the binary signals sequential from successive matrix rows into the pri elements of the column.

2. Data bit assembler as claimed in claim 1, characterised in that the matrix is formed by a plurality of shift registers, each individual one being operable for a serial readout of the binary signals therein.

3. Data bit assembler as claimed in claim 1, characterised in that prior to its readout each row of storage cells is addressed repeatedly with groups of data bits.

4. Data bit assembler as claimed in claim 2, characterised in that the shift registers are read out concurrently to respective groups of print elements (13).

5. Data bit assembler as claimed in claim 4, characterised in that the print elements (13) have associated supplemental storages for the readout from the said shift registers.

6. Data bit assembler as claimed in claim 1, characterised in that the buffer (22) is designed for a data bit shift by at least one column with respect to the data bit assembler.

7. Data bit assembler as claimed in claim 1, characterised in that the buffer (21) is designed for a data bit shift by a number of stages smaller than the number of columns of the data bit assembler (20).

8. Data bit assembler as claimed in claim 1, characterised in that between the circuit (23) designed as storage address register and the circuit (25) designed as address decoder circuit an address incrementing circuit (24) is inserted for changing the address of the successive rows of storage cells for storing additional bit groups until the entire data byte is stored, and in that a control circuit (27) is provided for transferring the data bits to the print elements (13) in serial form from the column positions in one row, and from a plurality of said rows.

9. Data bit assembler as claimed in claim 8, characterised in that the address incrementing circuit (24) increments the address by an amount equal to the number of data groups of one data byte.

10. Data bit assembler as claimed in claim 1, characterised in that the storage cells of the matrix (20) are settable from their reset state into their set state only when data are present for storage, irrespective of the number of times the storage cells are to be addressed.

## Revendications

1. Assembleur de bits de données pour une imprimante en matrice de points comportant plusieurs éléments d'impression imprimant chacun une colonne (14-1 à 15-1) et pouvant chacun être sélectivement commandé par des signaux binaires, une cellule de mémoire pour chaque élément d'impression (13), les cellules de mémoire prévues pour tous les éléments d'impression étant arrangées en matrice et les rangées de la matrice étant adressables pour un stockage en parallèle sélectif, caractérisé en ce que:

a) les cellules de mémoire permettent une lecture en série dans chacune des rangées de la matrice et les rangées de la matrice peuvent être lues en séquence;

b) une mémoire tampon (22) comporte une pluralité de positions de mémoire pour recevoir en parallèle au moins une partie des signaux binaires avant qu'ils ne soient stockés en série dans la matrice;

c) un sélecteur de bit (21) est connecté entre ladite mémoire tampon (22) et les colonnes de cellules de mémoire pour sélectionner à partir de la mémoire tampon un nombre de bits contigus correspondant au nombre des colonnes de la matrice, à l'aide d'un circuit de sélection (26), le premier de ces bits étant disponible à partir d'une position binaire quelconque de la mémoire tampon;

d) des circuits (23, 25) permettent l'adressage de rangées de la matrice prédéterminées pour un stockage successif de groupes de bits qui, après leur sélection par le sélecteur de bits, apparaîssent dans les colonnes des cellules de mémoire;

e) des circuits (27, 28, 29) permettent une lecture, en série par bit, des signaux binaires en séquence à partir des rangées successives de la matrice dans les éléments d'impression de la colonne.

2. Assembleur de bits de données selon la revendication 1, caractérisé en ce que la matrice est formée par plusieurs registres à décalage chacun servant à la lecture en série des signaux binaires.

3. Assembleur de bits de données selon la revendication 1, caractérisé en ce que des groupes de bits de données peuvent être enregistrés plusieurs fois dans chaque rangée de cellules de mémoire avant la lecture de la rangée.

4. Assembleur de bits de données selon la revendication 2, caractérisé en ce que les registres à décalage peuvent être lus simultanément, en fonction des groupes respectifs d'éléments d'impression (13).

5. Assembleur de bits de données selon la revendication 4, caractérisé en ce que les éléments d'impression (13) sont associés avec des mémoires complémentaires pour la lecture à partir desdits registres à décalage.

6. Assembleur de bits de données selon la revendication 1, caractérisé en ce que la mémoire tampon (22) peut décaler les bits de données d'au moins une colonne par rapport à l'assembleur de bits de données.

7. Assembleur de bits de données selon la revendication 1, caractérisé en ce que la mémoire tampon (22) peut décaler les bits de données d'un nombre de pas inférieur au nombre des colonnes de l'assembleur de bits de données (20).

8. Assembleur de bits de données selon la revendication 1, caractérisé en ce que: entre le circuit (23) formant le registre d'adresses de mémoire et le circuit (25) formant le circuit de décodage d'adresses est connecté un circuit d'incrémentation d'adresses (24) pour faire varier l'adresse des rangées successives de cellules de mémoire afin de stocker des groupes de bits supplémentaires jusqu'à ce que un octet complet de données soit stocké, et en ce que un circuit de commande (27) est prévu pour transférer les bits de données aux éléments d'impression (13) en série à partir des positions de colonnes dans une rangée et à partir d'une pluralité de ces rangées.

9. Assembleur de bits de données selon la revendication 8, caractérisé en ce que le circuit d'incrémentation d'adresses (24) incrémente l'adresse d'un nombre égal au nombre de groupes de données d'un octet de données.

10. Assembleur de bits de données selon la revendication 1, caractérisé en ce que les cellules de mémoire de la matrice (20) ne peuvent être amenées de leur état restauré dans leur état enclenché que lorsqu'il y a des données à stocker, quel que soit le nombre de fois où les cellules de mémoire doivent être adressées.

FIG. 1

FIG. 2

FIG. 3